# EUROPEAN PATENT SPECIFICATION

(11) **EP 4 661 237 B1**
(45) Date of publication and mention of the grant of the patent: **09.12.2026**
(21) Application number: 24179815.6
(22) Date of filing: 04.06.2024
(51) Int. Cl.: H02J 7/82, H02J 7/84, G01R 31/392, G01R 31/396, G01R 31/367, G01R 31/3842

(54) **OBTAINING STATE OF HEALTH AND STATE OF CHARGE OF A BATTERY**
ERHALT DES GESUNDHEITS- UND LADEZUSTANDS EINER BATTERIE
OBTENTION DE L'ÉTAT DE SANTÉ ET DE L'ÉTAT DE CHARGE D'UNE BATTERIE

(43) Date of publication of application: 10.12.2025
(73) Proprietor: Hitachi Energy Ltd, 8050 Zürich (CH)
(72) Inventor: LEI, Yu, Beijing, 100044 (CN); WANG, Yang, Beijing, 100077 (CN); LIU, Lu, Beijing, 100029 (CN); JIANG, Wen, Beijing, 102218 (CN); MENG, DeLun, Beijing, 100018 (CN); YANG, XiaoBo, Beijing, 100015 (CN); CHEN, Niya, Beijing, 100016 (CN)
(74) Representative: Vossius & Partner Patentanwälte Rechtsanwälte mbB

(56) References cited:
- US-A1- 20230 375 623
- DUQUE JOSIMAR ET AL: "Battery Dual Extended Kalman Filter State of Charge and Health Estimation Strategy for Traction Applications", 2022 IEEE TRANSPORTATION ELECTRIFICATION CONFERENCE & EXPO (ITEC), IEEE, 15 June 2022 (2022-06-15), pages 975 - 980, XP034145527, DOI: 10.1109/ITEC53557.2022.9813961

## Description

The present disclosure relates to a method, storage medium, device and system for obtaining a state of health (SOH) and state of charge (SOC) of a battery.

Josimar Duque et al.: "Battery Dual Extended Kalman Filter State of Charge and Health Estimation Strategy for Traction Applications", 2022 IEEE Transportation Electrification Conference & Expo (ITEC), 15 June 2022, pages 975-980, and US 2023/375623 A1 are documents of the related art.

For battery systems, e.g., lithium-ion battery systems, SOH is an important parameter to indicate the remaining capacity of a battery for further service. With an accurate value of SOH, the available battery capacity can be fully used to save costs and avoid damage to the battery. Generally, SOH cannot be measured directly during operation. Periodical capacity checks need to be completed to identify *Q*ₘₐₓ, and based thereon, the SOH can be calculated using the battery's rated capacity (*Qᵣ*)*,* as described in Equation (1): $SOH \left(t\right) = \frac{{Q}_{max} \left(t\right)}{{Q}_{r}}$ (1) where *Qᵣ* is the rated capacity of the battery and *Q*ₘₐₓ(*t*) is the maximum charge stored at time t in the battery.

To estimate the SOH under uncertain noise statistics in real-time, a Kalman filter (KF) may be used. The KF is a series of mathematical equations, providing an efficient computational method to estimate the state of a process while minimising the mean of the squared error in real-time. In a battery energy storage system (BESS), due to it being a nonlinear stochastic system, a partial derivative and Taylor series expansion may be utilised for the linearisation of the non-linear function, based on the KF. This may be referred to as extended Kalman filter (EKF).

For SOH, capacity fade with time in lithium-ion battery system is unavoidable due to the growth of the solid electrolyte interphase, decomposition reactions or irreversible lithium plating during cycling or even storage.

Furthermore, the values from a testing platform (e.g., current) can be disturbed by noise in the BESS. In addition, external disturbance may occur during operation. Thus, these biases can affect testing results. In the absence of exact statistical knowledge about the noise covariance matrices, it is difficult to yield an accurate SOH using EKF considering the uncertainty of the noise covariance of Q.

In other words, it is difficult to correctly estimate a SOH in real time and to reduce the influence of noise in the SOH estimation. Therefore, there is a need for an estimation of the current SOH in real-time during operation without waiting for a capacity check. This may provide substantial benefits vis-à-vis the prior art.

These and other objects are achieved with the current disclosure.

The invention is specified by the independent claims. Preferred embodiments are defined in the dependent claims. In the following description, although numerous features may be designated as optional, it is nevertheless acknowledged that all features comprised in the independent claims are not to be read as optional.

The present disclosure relates to a method for obtaining a state of health, SOH, and state of charge, SOC, of a battery. The method comprises obtaining (step 1) real-time voltage, real-time current, real-time temperature, initial SOC, and an initial SOH, obtaining (step 2) battery parameters from a look up table, LUT, based on the real-time current, real-time temperature, initial SOC, and initial SOH and obtaining (step 3) a new SOC and new SOH based on the battery parameters, real-time current, real-time voltage, initial SOC, and initial SOH.

Various embodiments may preferably implement the following features.

Preferably, the method further comprises iteratively performing the above steps using real-time battery parameters obtained from the LUT, and real-time current, real-time voltage, new SOC, and new SOH for obtaining an updated new SOC and updated new SOH.

Preferably, the method further comprises continuously performing the above steps for obtaining an updated new SOC and updated new SOH.

Preferably, the method further comprises generating, prior to step 1, the battery parameters of LUT from battery testing based on different SOHs, SOCs and temperatures, current. Preferably, the battery testing involves Hybrid Pulse Power Characterisation, HPPC, and/or Galvanostatic Intermittent Titration Technique, GITT.

Preferably, the battery parameters are equivalent circuit model, ECM, parameters.

Preferably, the ECM parameters comprise an open circuit voltage, OCV, resistance, and capacitance dependent on the real time data.

Preferably, obtaining (step 3) a new SOC and new SOH is performed based on dual Kalman filtering, in particular dual extended Kalman filtering.

Preferably, the initial SOC is obtained from a battery management system, BMS, connected to the battery, or capacity check of the battery.

Preferably, the initial SOH is obtained based on a capacity check of the battery.

Preferably, the battery is connected to a battery energy storage system, BESS.

Preferably, the method is performed on the BESS or on an external server.

The present disclosure further relates to a device for obtaining a state of health, SOH, and state of charge, SOC, of a battery, the device being connected to a battery and comprising a processor configured to obtain real-time voltage, real-time current, real-time temperature, initial SOC, and an initial SOH, obtain battery parameters from a look up table, LUT, based on the real-time current, real-time temperature, initial SOC, and initial SOH and obtain a new SOC and new SOH based on the battery parameters, real-time current, real-time voltage, initial SOC and initial SOH.

Preferably, the processor is further configured to perform the method as described above. The present disclosure also relates to a battery energy storage system, BESS, comprising at least one battery cell and a device as described above.

The present disclosure further relates to a computer-readable storage medium comprising instructions which, when executed by a processor, instruct the processor to perform the method described above.

Other aspects, features, and advantages will be apparent from the summary above, as well as from the description that follows, including the figures and the claims.

Embodiments of the present disclosure will now be described by way of example only and with reference to the following accompanying drawings. In the figures, the same reference numerals denote the same or similar elements.

Fig. 1 is a flowchart according to an embodiment of the present disclosure.

Fig. 2 is a flowchart according to an embodiment of the present disclosure.

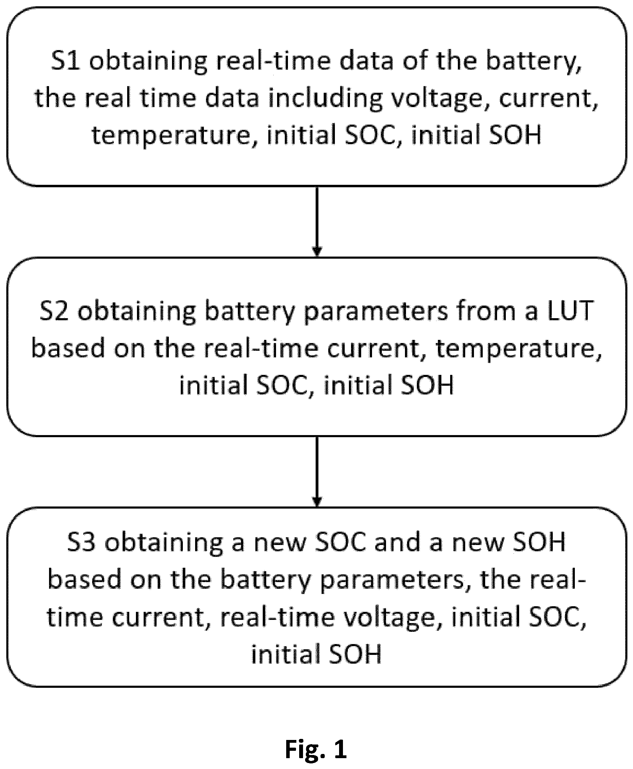

Referring to Fig. 1, the present disclosure relates to a method for obtaining a state of health (SOH) and state of charge (SOC) of a battery. The method comprises obtaining S1 real-time data of the battery, the real time data including voltage, current, temperature, initial SOC, and an initial SOH, obtaining S2 battery parameters from a look up table (LUT) based on the real-time current, temperature, initial SOC, and initial SOH and obtaining S3 a new SOC and new SOH based on the battery parameters, real-time current, real-time voltage, initial SOC, and initial SOH.

As used herein, the term obtaining, in particular in the context of step S3, may be equivalent to estimating or determining. These terms may thus be used synonymously in the present disclosure.

In an embodiment, the method further comprises iteratively performing the above steps S1 to S3 using real-time battery parameters obtained from the LUT, and real-time current, real-time voltage, new SOC, and new SOH for obtaining an updated new SOC and updated new SOH.

In an embodiment, the method further comprises continuously performing the above steps for obtaining an updated new SOC and updated new SOH.

That is, in the above steps, the new SOC/new SOH replaces the initial SOC/initial SOH, respectively, for the next iteration of obtaining the battery parameters from the LUT and obtaining the updated SOC/updated SOH. Also, current real-time data of voltage, current and temperature replaces the previous current, voltage and temperature data. In other words, the method uses the latest dataset in order to provide an updated SOC/SOH estimation in real time. Every datapoint of measured current, voltage, temperature, SOC and SOH may only be used once until replaced by a more recent version.

In an embodiment, the method further comprises generating, prior to S1, the battery parameters of LUT from battery testing based on different SOHs, SOCs, temperatures, and currents.

In an embodiment, the battery testing involves Hybrid Pulse Power Characterisation (HPPC) and/or Galvanostatic Intermittent Titration Technique (GITT). However, the present disclosure is not limited thereto and any method for obtaining said battery parameters may be employed.

The LUT may remain unchanged during performing the method. In an embodiment, the LUT may remain unchanged during the life cycle of a battery or battery cell.

In an embodiment, the battery parameters are equivalent circuit model (ECM), parameters. In an embodiment, the ECM parameters comprise an open circuit voltage (OCV) resistance, and capacitance dependent on the real time data.

The GITT and HPPC may be used to identify the ECM parameters (e.g., OCV, R0, R1, R2, C1, C2) stored in the LUT. For a regular charging/discharging test, the real-time data of voltage, current, and temperature is obtained for SOC and SOH estimation.

In an embodiment, estimating S3 a new SOC and new SOH is performed based on dual Kalman filtering, in particular dual extended Kalman filtering.

In an embodiment, the initial SOC is obtained from a battery management system (BMS) connected to the battery, or capacity check of the battery.

In an embodiment, the initial SOH is obtained based on a capacity check of the battery.

In an embodiment, the battery is connected to a battery energy storage system (BESS). In an embodiment, the method is performed on the BESS or on an external server.

The present disclosure further relates to a corresponding device for estimating an SOH and SOC of a battery, the device being connected to a battery and comprising a processor configured to obtain real-time data of the battery, the real time data including voltage, current, temperature, initial SOC, and an initial SOH, obtain battery parameters from a LUT based on the real-time data current, temperature, initial SOC, and initial SOH and estimate a new SOC and new SOH based on the battery parameters, real-time current, real-time voltage, initial SOC and initial SOH.

The processor may further be configured to perform the method as described above.

The device may be a battery management system (BMS) or may be comprised in a BMS. The device may also be a server or a computing device external to the BMS (located in the vicinity of the BMS or at a remote location).

The present disclosure also relates to a BESS comprising at least one battery cell and a device as described above.

The present disclosure further relates to a computer-readable storage medium comprising instructions which, when executed by a processor, instruct the processor to perform the method described above.

The current disclosure is applicable to a cell-level, module-level and/or rack-level of a battery system. That is, it may be used for isolated cells or a plurality of connected cells.

The disclosure will be described in more detail below. All embodiments disclosed herein are, unless indicated otherwise, fully compatible with each other.

For an accurate SOH estimation in real-time, an SOH estimator is proposed. In particular, the present disclosure may relate to an SOH estimator based on an EKF. Based on an exemplary ECM with two resistor-capacitor (RC) branches for a battery system such as a lithium-ion battery system, the state and measurement variables may be calculated using equation (2) and equation (3), respectively.

In these equations, some ECM parameters (OCV, R₀, R₁, R₂, C₁, C₂, $\frac{{dV}_{OCV} \left(SOC\right)}{dSOC}$) may be obtained from the test of hybrid pulse power characterization (HPPC) for discharging process and galvanostatic intermittent titration technique (GITT) for charging process. As outlined above, such battery parameters may be stored in a LUT. Therefore, a LUT of ECM parameters from testing results of HPPC and GITT may be used as the input in the EKF of SOH estimator. $\left\{\begin{matrix}{C}_{N , k} = {C}_{N , k - 1} \\ {V}_{OCV} \left({SOC}_{k}\right) = {V}_{OCV} \left({SOC}_{k - 1}\right) - {\left.\frac{{dv}_{OCV} \left(SOC\right)}{dSOC}\right|}_{k - 1} \frac{{I}_{k - 1}}{{C}_{N , k - 1}} \\ {V}_{1 , k} = {e}^{- t / {R}_{1} {C}_{1}} {V}_{1 , k - 1} + {R}_{1} \left(1-{e}^{- t / {R}_{1} {C}_{1}}\right) ∗ {I}_{k - 1} \\ {V}_{2 , k} = {e}^{- t / {R}_{2} {C}_{2}} {V}_{2 , k - 1} + {R}_{2} \left(1-{e}^{- t / {R}_{2} {C}_{2}}\right) ∗ {I}_{k - 1}\end{matrix}\right.$ (2) ${V}_{0 , k} = {V}_{OCV , k} - {V}_{1 , k} - {V}_{2 , k} - {R}_{0} {I}_{k}$ (3)

In the above, *C_{N}* denotes a maximum charge stored in battery, *R*₁ and *C*₁ denote a polarisation resistor and capacitor, *R*₂ and *C*₂ denote a diffusion resistor and capacitor, *V*₁ and *V*₂ indicate voltages across capacitor *C*₁ and *C*₂ *, V_{OCV}* is the open circuit voltage, *V*₀ is the terminal voltage, *I* is the current through the circuit system, *R*₀ is the internal resistance, *k* is the index (current iteration) and *t* is the sampling time.

The output (step S3) of the above is a new *SOHₖ* which may be used for subsequent estimations.

In particular, the maximum charge *C_{N}* stored in the battery is the output based on the estimation using equations (2) and (3). The battery's rated capacity (which is assumed to be a constant value) is used to calculate the SOH as described in equation (1). Then, this SOH (as well as the SOC output from equations (4) and (5) below, real-time current, real-time temperature) is used to obtain the battery parameters from the LUT.

To obtain (step S2) the ECM parameters from the LUT in real-time, beside current and temperature, the input of (a current) SOC and SOH may also be provided in real-time (step S1). To increase the accuracy of SOH estimator and decrease the effect of noise, another EKF estimator for SOC is accompanied with SOH estimator, forming a dual extended Kalman filter (DEKF) system. In this SOC estimator, the same ECM with two RC branches for the battery system may be utilised as SOH estimator with the state and measurement variables described in equation (4) and equation (5), respectively. Note that these ECM parameters are obtained from the same LUT as above for the SOH estimator. $\left\{\begin{matrix}{SOC}_{k} = {SOC}_{k - 1} + t / {C}_{N} ∗ {I}_{k - 1} \\ {V}_{1 , k} = {e}^{- t / {R}_{1} {C}_{1}} {V}_{1 , k - 1} + {R}_{1} \left(1-{e}^{- t / {R}_{1} {C}_{1}}\right) ∗ {I}_{k - 1} \\ {V}_{2 , k} = {e}^{- t / {R}_{2} {C}_{2}} {V}_{2 , k - 1} + {R}_{2} \left(1-{e}^{- t / {R}_{2} {C}_{2}}\right) ∗ {I}_{k - 1}\end{matrix}\right.$ (4) ${V}_{0 , k} = {V}_{OCV , k} - {V}_{1 , k} - {V}_{2 , k} - {R}_{0} {I}_{k}$ (5)

From the above, the current *SOCₖ* is estimated or obtained.

In particular, the SOC values obtained by equations (4) and (5) and SOH values obtained using equations (2) and (3) (in combination with real-time current and real-time temperature) are used to obtain the battery parameters from the LUT (OCV, R0, R1, R2, C1, C2). These parameters may subsequently be used for the calculation of *V*₁ and *V*₂, as described above. Considering the measured voltage value of *V*₀, which may be obtained from the real-time data of the BMS, this is used together with *V*₁, *V*₂*, V_{OCV},* etc.

The calculations aiming for an optimal estimate of SOC using an EKF algorithm may minimize a mean squared error.

The described DEKF according to an embodiment consists of an SOH estimator and an SOC estimator (see above) to synchronously estimate the state of a battery during operation in real-time. In this case, real-time values of SOC and SOH are simultaneously input into a LUT to obtain ECM parameters as described above. These ECM parameters are then input into the state and measurement equations of the DEKF. Thereby, both accuracy and performance of the two estimators can be improved. Due to the presence of state and measurement noise, to further increase the accuracy and the reliability of DEKF, Q may be optimised before running the DEKF.

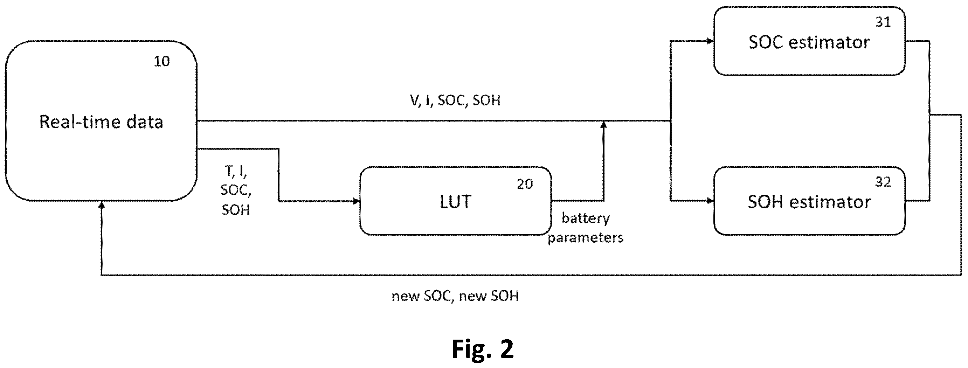

The above is further illustrated with reference to Fig. 2 showing an embodiment of the present disclosure.

As described above, real-time data is acquired in block 10 (i.e., step S1). The real-time data comprises real-time voltage, real-time current, real-time temperature, (initial) SOC and (initial) SOH. This real-time data may be obtained or measured. That is, at least some of the data may be externally provided or stored.

The real-time temperature, real-time current, initial SOC and initial SOH are fed into the LUT in block 20 to obtain the relevant battery parameters (i.e., step S2).

These obtained battery parameters are provided together with the initial SOC, initial SOH, real-time current and real-time voltage data to the SOC estimator 31 and the SOH estimator 32. The blocks estimate a new SOC and a new SOH (updated SOC/SOH), respectively, as described above (i.e., step S3).

The SOC estimator 31 utilises the above equations (4) and (5) while the SOH estimator 32 utilises the above equations (2) and (3) to estimate a new SOC and new SOH, respectively.

Subsequently, the method is repeated using the new SOC and new SOH as well as the real-time temperature and real-time current to obtain updated battery parameters from the LUT 20. These battery parameters as well as the real-time voltage, real-time current, new SOC and new SOH are input to the SOC estimator 31 and SOH estimator 32 to estimate updated SOC and updated SOH.

In the next iteration, the updated SOC and SOH replace the previously used new SOC and new SOH and real-time current, voltage and temperature replace the respective previously used data.

The method may be iteratively performed, continuously performed, or until a certain termination condition is fulfilled. E.g., the method may be performed until a certain threshold of a voltage, SOC or SOH is reached.

The current may be used to determine whether the battery is used in a charging or a discharging mode. That is, in case of a positive current, the battery may be determined to be in a discharging mode and in case of a negative current, the battery may be determined to be in a charging mode (when viewed from a battery tester's perspective).

By using the combination of SOC and SOH estimators, the noise occurring in the system may be reduced by the SOC estimator and thus an accurate estimation of the current SOH may be achieved.

In summary, the present disclosure may comprise generating or obtaining a LUT including OCV, resistance, capacitance as well as $\frac{{dV}_{OCV} \left(SOC\right)}{dSOC}$ based on different temperature, current, SOC and SOH values. Such generation may be performed in a laboratory or during a manufacturing process of the battery. Then, real-time data of *I, T, V ,* initial SOC from a battery management system (BMS) and the battery parameters from the LUT may be provided to the DEKF for performing the above method. Both cell-level and rack-level data can be used as the input. The method, i.e., the DEKF, is used to obtain a real-time SOH estimation.

Note that the state noise covariance matrix (Q) and the measurement noise covariance matrix (R) may be relevant for the algorithm of EKF. In an embodiment, the state noise covariance matrix Q may be used for the state equations (equations (2) and (4)) while the measurement noise covariance matrix R may be used for the measurement equations (equations (3) and (5)). Accurate values of these noise covariance matrices can improve the accuracy and performance of real-time estimation of SOH in the BESS.

According to the present disclosure, an accurate and reliable method for estimating a current SOH and SOC has been provided. With this data, the state of the battery or battery system may be monitored and the battery system may be used to full capacity. Further, by monitoring the battery health, the battery may be efficiently used and a life cycle of the battery may be prolonged.

While various embodiments of the present disclosure have been described above, it should be understood that they have been presented by way of example only, and not by way of limitation. Likewise, the various diagrams may depict an example architectural or configuration, which are provided to enable persons of ordinary skill in the art to understand exemplary features and functions of the present disclosure. Such persons would understand, however, that the present disclosure is not restricted to the illustrated example architectures or configurations, but can be implemented using a variety of alternative architectures and configurations. Additionally, as would be understood by persons of ordinary skill in the art, one or more features of one embodiment can be combined with one or more features of another embodiment described herein. Thus, the breadth and scope of the present disclosure should not be limited by any one of the above-described exemplary embodiments.

It is also understood that any reference to an element herein using a designation such as "first," "second," and so forth does not generally limit the quantity or order of those elements. Rather, these designations can be used herein as a convenient means of distinguishing between two or more elements or instances of an element. Thus, a reference to first and second elements does not mean that only two elements can be employed, or that the first element must precede the second element in some manner.

Additionally, a person having ordinary skill in the art would understand that information and signals can be represented using any one of a variety of different technologies and techniques. For example, data, instructions, commands, information, signals, bits and symbols, for example, which may be referenced in the above description can be represented by voltages, currents, electromagnetic waves, magnetic fields or particles, optical fields or particles, or any combination thereof.

A skilled person would further appreciate that any one of the various illustrative logical blocks, units, processors, means, circuits, methods and functions described in connection with the aspects disclosed herein can be implemented by electronic hardware (e.g., a digital implementation, an analog implementation, or a combination of the two), firmware, various forms of program or design code incorporating instructions (which can be referred to herein, for convenience, as "software" or a "software unit"), or any combination of these techniques.

To clearly illustrate this interchangeability of hardware, firmware and software, various illustrative components, blocks, units, circuits, and steps have been described above generally in terms of their functionality. Whether such functionality is implemented as hardware, firmware or software, or a combination of these techniques, depends upon the particular application and design constraints imposed on the overall system. Skilled artisans can implement the described functionality in various ways for each particular application, but such implementation decisions do not cause a departure from the scope of the present disclosure. In accordance with various embodiments, a processor, device, component, circuit, structure, machine, unit, etc. can be configured to perform one or more of the functions described herein. The term "configured to" or "configured for" as used herein with respect to a specified operation or function refers to a processor, device, component, circuit, structure, machine, unit, etc. that is physically constructed, programmed and/or arranged to perform the specified operation or function.

Furthermore, a skilled person would understand that various illustrative logical blocks, units, devices, components and circuits described herein can be implemented within or performed by an integrated circuit (IC) that can include a general purpose processor, a digital signal processor (DSP), an application specific integrated circuit (ASIC), a field programmable gate array (FPGA) or other programmable logic device, or any combination thereof. The logical blocks, units, and circuits can further include antennas and/or transceivers to communicate with various components within the network or within the device. A general purpose processor can be a microprocessor, but in the alternative, the processor can be any conventional processor, controller, or state machine. A processor can also be implemented as a combination of computing devices, e.g., a combination of a DSP and a microprocessor, a plurality of microprocessors, one or more microprocessors in conjunction with a DSP core, or any other suitable configuration to perform the functions described herein. If implemented in software, the functions can be stored as one or more instructions or code on a computer-readable medium. Thus, the steps of a method or algorithm disclosed herein can be implemented as software stored on a computer-readable medium.

Computer-readable media includes both computer storage media and communication media including any medium that can be enabled to transfer a computer program or code from one place to another. A storage media can be any available media that can be accessed by a computer. By way of example, and not limitation, such computer-readable media can include RAM, ROM, EEPROM, CD-ROM or other optical disk storage, magnetic disk storage or other magnetic storage devices, or any other medium that can be used to store desired program code in the form of instructions or data structures and that can be accessed by a computer.

In this document, the term "unit" as used herein, refers to software, firmware, hardware, and any combination of these elements for performing the associated functions described herein. Additionally, for purpose of discussion, the various units are described as discrete units; however, as would be apparent to one of ordinary skill in the art, two or more units may be combined to form a single unit that performs the associated functions according embodiments of the present disclosure.

Additionally, memory or other storage, as well as communication components, may be employed in embodiments of the present disclosure. It will be appreciated that, for clarity purposes, the above description has described embodiments of the present disclosure with reference to different functional units and processors. However, it will be apparent that any suitable distribution of functionality between different functional units, processing logic elements or domains may be used without detracting from the present disclosure. For example, functionality illustrated to be performed by separate processing logic elements, or controllers, may be performed by the same processing logic element, or controller. Hence, references to specific functional units are only references to a suitable means for providing the described functionality, rather than indicative of a strict logical or physical structure or organisation.

Various modifications to the implementations described in this disclosure will be readily apparent to those skilled in the art, and the general principles defined herein can be applied to other implementations without departing from the scope of this disclosure. Thus, the disclosure is not intended to be limited to the implementations shown herein, but is to be accorded the widest scope consistent with the appended claims.

## Claims

1. Method for obtaining a state of health, SOH, and state of charge, SOC, of a battery, the method comprising:
obtaining (S1) real-time voltage, real-time current, real-time temperature, initial SOC, and an initial SOH;
obtaining (S2) battery parameters from a look up table, LUT, based on the real-time current, real-time temperature, initial SOC, and initial SOH; and
obtaining (S3) a new SOC and new SOH based on the battery parameters, real-time current, real-time voltage, initial SOC, and initial SOH.

2. Method according to claim 1, further comprising iteratively performing steps (S1) to (S3) using real-time battery parameters obtained from the LUT, and real-time current, real-time voltage, new SOC, and new SOH for obtaining an updated new SOC and updated new SOH.

3. Method according to claim 1 or 2, further comprising continuously performing steps (S1) to (S3) for obtaining an updated new SOC and updated new SOH.

4. Method according to any one of claims 1 to 3, further comprising generating, prior to step (S1), the battery parameters of LUT from battery testing based on different SOHs, SOCs and temperatures, current.

5. Method according to claim 4, wherein the battery testing involves Hybrid Pulse Power Characterisation, HPPC, and/or Galvanostatic Intermittent Titration Technique, GITT.

6. Method according to any one of claims 1 to 5, wherein the battery parameters are equivalent circuit model, ECM, parameters,
wherein the ECM parameters preferably comprise an open circuit voltage, OCV, resistance, and capacitance dependent on the real time data.

7. Method according to any one of claims 1 to 6, wherein obtaining (S3) a new SOC and new SOH is performed based on dual Kalman filtering, in particular dual extended Kalman filtering.

8. Method according to any one of claims 1 to 7, wherein the initial SOC is obtained from a battery management system, BMS, connected to the battery, or capacity check of the battery.

9. Method according to any one of claims 1 to 7, wherein the initial SOH is obtained based on a capacity check of the battery.

10. Method according to any one of claims 1 to 9, wherein the battery is connected to a battery energy storage system, BESS.

11. Method according to claim 10, wherein the method is performed on the BESS or on an external server.

12. Device for obtaining a state of health, SOH, and state of charge, SOC, of a battery, the device being connected to a battery and comprising a processor configured to:
obtain real-time voltage, real-time current, real-time temperature, initial SOC, and an initial SOH;
obtain battery parameters from a look up table, LUT, based on the real-time current, real-time temperature, initial SOC, and initial SOH; and
obtain a new SOC and new SOH based on the battery parameters, real-time current, real-time voltage, initial SOC and initial SOH.

13. Device according to claim 12, wherein the processor is further configured to perform the method according to any one of claims 2 to 11.

14. Battery energy storage system, BESS, comprising:
at least one battery cell;
a device according to claim 12 or 13.

15. Computer-readable storage medium comprising instructions which, when executed by a processor, instruct the processor to perform the method according to any one of claims 1 to 11.

## Patentansprüche

1. Verfahren zum Erhalten eines Alterungszustands, SOH, und eines Ladezustands, SOC, einer Batterie, wobei das Verfahren Folgendes umfasst:
Erhalten (S1) einer Echtzeitspannung, eines Echtzeitstroms, einer Echtzeittemperatur, eines anfänglichen SOC und eines anfänglichen SOH;
Erhalten (S2) von Batterieparametern aus einer Nachschlagetabelle, LUT, basierend auf dem Echtzeitstrom, der Echtzeittemperatur, dem anfänglichen SOC und dem anfänglichen SOH; und
Erhalten (S3) eines neuen SOC und eines neuen SOH basierend auf den Batterieparametern, dem Echtzeitstrom, der Echtzeitspannung, dem anfänglichen SOC und dem anfänglichen SOH.

2. Verfahren nach Anspruch 1, das ferner iteratives Durchführen der Schritte (S1) bis (S3) unter Verwendung der aus der LUT erhaltenen Echtzeitbatterieparameter und des Echtzeitstroms, der Echtzeitspannung, des neuen SOC und des neuen SOH zum Erhalten eines aktualisierten neuen SOC und eines aktualisierten neuen SOH umfasst.

3. Verfahren nach Anspruch 1 oder 2, das ferner kontinuierliches Durchführen der Schritte (S1) bis (S3) zum Erhalten eines aktualisierten neuen SOC und eines aktualisierten neuen SOH umfasst.

4. Verfahren nach einem der Ansprüche 1 bis 3, das vor dem Schritt (S1) ferner Erzeugen der Batterieparameter der LUT aus Batterietests basierend auf unterschiedlichen SOHs, SOCs, Temperaturen und Strom, umfasst.

5. Verfahren nach Anspruch 4, wobei die Batterietests die Hybrid Pulse Power Characterisation, HPPC, und/oder die Galvanostatic Intermittent Titration Technique, GITT, beinhalten.

6. Verfahren nach einem der Ansprüche 1 bis 5, wobei die Batterieparameter Equivalent-Circuit-Model-Parameter, ECM-Parameter, sind,
wobei die ECM-Parameter vorzugsweise eine Leerlaufspannung, OCV, einen Widerstand und eine Kapazität in Abhängigkeit von den Echtzeitdaten umfassen.

7. Verfahren nach einem der Ansprüche 1 bis 6, wobei das Erhalten (S3) eines neuen SOC und eines neuen SOH basierend auf einer dualen Kalman-Filterung, insbesondere einer dualen erweiterten Kalman-Filterung, durchgeführt wird.

8. Verfahren nach einem der Ansprüche 1 bis 7, wobei der anfängliche SOC aus einem mit der Batterie verbundenen Batteriemanagementsystem, BMS, oder einer Kapazitätsprüfung der Batterie erhalten wird.

9. Verfahren nach einem der Ansprüche 1 bis 7, wobei der anfängliche SOH basierend auf einer Kapazitätsprüfung der Batterie erhalten wird.

10. Verfahren nach einem der Ansprüche 1 bis 9, wobei die Batterie mit einem Batterieenergiespeichersystem, BESS, verbunden ist.

11. Verfahren nach Anspruch 10, wobei das Verfahren in dem BESS oder auf einem externen Server durchgeführt wird.

12. Vorrichtung zum Erhalten eines Alterungszustands, SOH, und eines Ladezustands, SOC, einer Batterie, wobei die Vorrichtung mit einer Batterie verbunden ist und einen Prozessor umfasst, der zu Folgendem konfiguriert ist:
Erhalten einer Echtzeitspannung, eines Echtzeitstroms, einer Echtzeittemperatur, eines anfänglichen SOC und eines anfänglichen SOH;
Erhalten von Batterieparametern aus einer Nachschlagetabelle, LUT, basierend auf dem Echtzeitstrom, der Echtzeittemperatur, dem anfänglichen SOC und dem anfänglichen SOH; und
Erhalten eines neuen SOC und eines neuen SOH basierend auf den Batterieparametern, dem Echtzeitstrom, der Echtzeitspannung, dem anfänglichen SOC und dem anfänglichen SOH.

13. Vorrichtung nach Anspruch 12, wobei der Prozessor ferner dazu konfiguriert ist, das Verfahren nach einem der Ansprüche 2 bis 11 durchzuführen.

14. Batterieenergiespeichersystem, BESS, das Folgendes umfasst:
mindestens eine Batteriezelle;
eine Vorrichtung nach Anspruch 12 oder 13.

15. Computerlesbares Speichermedium, das Anweisungen umfasst, die, wenn sie durch einen Prozessor ausgeführt werden, den Prozessor anweisen, das Verfahren nach einem der Ansprüche 1 bis 11 durchzuführen.

## Revendications

1. Procédé d'obtention d'un état de santé, SOH, et d'un état de charge, SOC, d'une batterie, le procédé comprenant les étapes suivantes :
obtenir (S1) une tension en temps réel, un courant en temps réel, une température en temps réel, un SOC initial et un SOH initial ;
obtenir (S2) des paramètres de batterie à partir d'une table de consultation, LUT, sur la base du courant en temps réel, de la température en temps réel, du SOC initial et du SOH initial ; et
obtenir (S3) un nouveau SOC et un nouveau SOH sur la base des paramètres de la batterie, du courant en temps réel, de la tension en temps réel, du SOC initial et du SOH initial.

2. Procédé selon la revendication 1, comprenant en outre la réalisation itérative des étapes (S1) à (S3) en utilisant les paramètres de batterie en temps réel obtenus à partir de la LUT, et le courant en temps réel, la tension en temps réel, un nouveau SOC et un nouveau SOH pour obtenir un nouveau SOC mis à jour et un nouveau SOH mis à jour.

3. Procédé selon les revendications 1 ou 2, comprenant en outre l'exécution continue des étapes (S1) à (S3) pour obtenir un nouveau SOC mis à jour et un nouveau SOH mis à jour.

4. Procédé selon l'une quelconque des revendications 1 à 3, comprenant en outre la génération, avant l'étape (S1), des paramètres de batterie de la LUT à partir d'un test de batterie basé sur différents SOH, SOC, températures et courant.

5. Procédé selon la revendication 4, dans lequel le test de batterie implique une caractérisation de puissance d'impulsion hybride, HPPC, et/ou une technique de titrage intermittent galvanostatique, GITT.

6. Procédé selon l'une quelconque des revendications 1 à 5, dans lequel les paramètres de batterie sont des paramètres de modèle de circuit équivalent, ECM,
où les paramètres d'ECM comprennent, de préférence, une tension à vide, OCV, une résistance et une capacité dépendant des données en temps réel.

7. Procédé selon l'une quelconque des revendications 1 à 6, dans lequel l'obtention (S3) d'un nouveau SOC et d'un nouveau SOH est effectuée par double filtrage de Kalman, notamment par double filtrage de Kalman étendu.

8. Procédé selon l'une quelconque des revendications 1 à 7, dans lequel le SOC initial est obtenu à partir d'un système de gestion de batterie, BMS, connecté à la batterie, ou d'un contrôle de capacité de la batterie.

9. Procédé selon l'une quelconque des revendications 1 à 7, dans lequel le SOH initial est obtenu sur la base d'un contrôle de capacité de la batterie.

10. Procédé selon l'une quelconque des revendications 1 à 9, dans lequel la batterie est reliée à un système de stockage d'énergie par batterie, BESS.

11. Procédé selon la revendication 10, dans lequel le procédé est exécuté sur le BESS ou sur un serveur externe.

12. Dispositif d'obtention d'un état de santé, SOH, et d'un état de charge, SOC, d'une batterie, le dispositif étant connecté à une batterie et comprenant un processeur configuré pour :
obtenir une tension en temps réel, un courant en temps réel, une température en temps réel, un SOC initial et un SOH initial ;
obtenir des paramètres de batterie à partir d'une table de consultation, LUT, sur la base du courant en temps réel, de la température en temps réel, du SOC initial et du SOH initial ; et
obtenir un nouveau SOC et un nouveau SOH sur la base des paramètres de la batterie, du courant en temps réel, de la tension en temps réel, du SOC initial et du SOH initial.

13. Dispositif selon la revendication 12, dans lequel le processeur est en outre configuré pour exécuter le procédé selon l'une quelconque des revendications 2 à 11.

14. Système de stockage d'énergie par batterie, BESS, comprenant :
au moins une cellule de batterie ;
un dispositif selon les revendications 12 ou 13.

15. Support de stockage lisible par ordinateur comprenant des instructions qui, lorsqu'elles sont exécutées par un processeur, donnent pour instruction au processeur d'exécuter le procédé selon l'une quelconque des revendications 1 à 11.
